# EUROPÄISCHE PATENTANMELDUNG

(11) **EP 4 742 880 A2**
(43) Veröffentlichungstag der Anmeldung: **13.05.2026**
(21) Anmeldenummer: 25209680.5
(22) Anmeldetag: 20.10.2025
(51) Int. Cl.: H10P 72/00, C23C 14/52, C23C 14/56

(54) **SCHUTZVORRICHTUNG, ERFASSUNGSSYSTEM UND VERWENDUNG DESSEN**

(30) Priorität: 11.11.2024 DE 102024132765
(71) Anmelder: VON ARDENNE Asset GmbH & Co. KG, 01328 Dresden (DE)
(72) Erfinder: Hofmann, Michael, 01277 Dresden (DE); Dsaak, Torsten, 01279 Dresden (DE); Leßmann, Steffen, 01157 Dresden (DE)

(57) **Zusammenfassung**

Gemäß verschiedenen Ausführungsformen weist eine Schutzvorrichtung, auf: ein erstes Gehäuseteil (102) und ein zweites Gehäuseteil (104), welche eingerichtet sind, ineinandergesteckt zu werden zum Bilden eines Überdruckgehäuses (150), in welchem ein Hohlraum (151) zum Aufnehmen einer optischen Erfassungsvorrichtung (202) bereitgestellt ist; wobei das erste Gehäuseteil (102) einen transparenten Lichtaufnahmebereich (112) aufweist, welcher an den Hohlraum (151) angrenzt; eine dem Lichtaufnahmebereich (112) gegenüberliegende Montagevorrichtung (110) zum Montieren einer oder mehr als einer Fluidleitung an das Überdruckgehäuse (150); ein erster Fluidtransferkanal (106) und ein zweiter Fluidtransferkanal (116), wovon jeder Fluidtransferkanal den Hohlraum (151) mit der Montagevorrichtung fluidleitend koppelt oder in der Montagevorrichtung mündet.

## Beschreibung

Verschiedene Ausführungsbeispiele betreffen eine Schutzvorrichtung, eine Erfassungssystem und Verwendung dessen.

Im Allgemeinen kann ein Substrat in einem Vakuum behandelt (prozessiert), z.B. beschichtet werden, so dass die chemischen und/oder physikalischen Eigenschaften des Substrats verändert werden können. Zum Beschichten eines Substrats können verschiedene Beschichtungsverfahren durchgeführt werden, wovon die physikalische Gasphasenabscheidung (PVD) ein etablierter Vertreter ist. Beispielsweise kann eine Vakuumbeschichtungsanlage genutzt werden, um eine Schicht oder mehrere Schichten mittels einer chemischen und/oder physikalischen Gasphasenabscheidung auf einem Substrat oder auf mehreren Substraten abzuscheiden.

Hierbei können verschiedene Bereiche im Vakuum schwer zugänglich und/oder betriebsfeindlichen Umgebungsbedingungen ausgesetzt sein. Soll ein solcher Bereich optisch überwacht werden, z.B. Bildinformationen davon bereitgestellt werden, fällt die dazu eingesetzte Kamera oft aus, ist teuer, benötigt zu viel Bauraum und/oder kann den Bereich nur unzureichend erfassen. Ein Beispiel hierfür ist das schwer zugängliche Wartungsventil, für welches es von Interesse sein kann, ob ein Substrat in der Substrattransferöffnung (auch als Durchfahrtsschlitz bezeichnet) liegt. Dies gilt in Analogie für andere Bereiche einer Maschine, die nicht notwendigerweise einem Vakuum ausgesetzt sein müssen.

Verschiedene hierin bereitgestellte Ausführungsformen adressieren dieses Dilemma. Gemäß verschiedenen Ausführungsformen wird eine Schutzvorrichtung, ein Erfassungssystem und ein Verwenden dessen bereitgestellt, welche das optische Erfassen in einem schwer zugänglichen Bereich und/oder betriebsfeindlichen Umgebungsbedingungen erleichtern. Hierfür wird exemplarisch auf einen Bereich Bezug genommen, in dem ein Vakuum gebildet ist, wobei das hierfür Beschriebene in Analogie gelten kann für jeden anderen Bereich, z.B. schwer zugänglichen Bereich und/oder betriebsfeindliche Umgebungsbedingungen, wofür Beispiele aufweisen: eine korrosive Atmosphäre, ein Überdruck, Staub (z.B. Abrieb) oder ein Beschichtungsmaterial eines Beschichtungsprozesses.

Gemäß verschiedenen Ausführungsformen weist die Schutzvorrichtung einen geringen Platzbedarf durch eine kompakte Bauweise auf und bietet Schutz vor betriebsfeindlichen Umgebungsbedingungen. Unter anderem wird dadurch ermöglicht, eine optische Erfassungsvorrichtung näher am zu erfassenden Bereich anzuordnen, z.B. im Vakuum und/oder einem Beschichtungsprozess ausgesetzt. Dies verbessert den Zugang im Vergleich zu einem üblichen Kammerfenster, das in einer Kammerwand einer Vakuumkammer bereitgestellt ist. Gegenüber dem Kammerfenster wird beispielsweise der Spielraum für die Einblicksmöglichkeit und die Perspektive (den Einblickswinkel) vergrößert.

Ferner wird die Erfassungsvorrichtung wirkungsvoll gegenüber den Umgebungsbedingungen geschützt, womit diese nicht notwendigerweise vakuumtauglich sein muss, besser gekühlt werden kann und näher an der Quelle schädlicher Umgebungsbedingungen angeordnet werden kann. Insbesondere wird die Lebensdauer der Erfassungsvorrichtung vergrößert und Anforderungen (beispielsweise an die Temperaturbeständigkeit und/oder Staubdichtheit) an dieser reduziert, was diese kostengünstiger macht.

Im Folgenden werden verschiedene Beispiele beschrieben, die sich auf hierin Beschriebene und in den Figuren Dargestellte beziehen.

Beispiel 1 ist eingerichtet gemäß einem der beigefügten Ansprüche und/oder ist eine Schutzvorrichtung, vorzugsweise (z.B. eingerichtet als Kameraschutzvorrichtung) für ein optisches (z.B. optoelektronisches) Bauteil (z.B. eine Erfassungsvorrichtung, insbesondere eine Kamera), aufweisend: ein erstes Gehäuseteil und ein zweites Gehäuseteil, welche eingerichtet sind, ineinandergesteckt zu werden zum Bilden eines Überdruckgehäuses, in welchem ein Hohlraum (auch als Aufnahmeraum bezeichnet) zum Aufnehmen des Bauteils (z.B. der Erfassungsvorrichtung) bereitgestellt ist; wobei das erste Gehäuseteil einen transparenten Lichtaufnahmebereich (auch Schaubereich als bezeichnet) aufweist, welcher an den Hohlraum (entlang einer Erfassungsrichtung) angrenzt; eine dem Lichtaufnahmebereich gegenüberliegende Montagevorrichtung (auch als Fluid-Montagevorrichtung bezeichnet) zum Montieren (z.B. Kupplungsvorrichtung zum Ankuppeln) einer oder mehr als einer Fluidleitung (z.B. an das Überdruckgehäuse); einen oder mehr als einen Fluidtransferkanal (z.B. einen ersten Fluidtransferkanal, einen zweiten Fluidtransferkanal und/oder einen dritten Fluidtransferkanal aufweisend), wovon jeder Fluidtransferkanal den Hohlraum mit der Montagevorrichtung (z.B. einer Öffnung dieser) fluidleitend koppelt oder in der Montagevorrichtung mündet.

Beispiel 2 (z.B. eine Schutzvorrichtung) ist eingerichtet gemäß Beispiel 1, wobei das erste Gehäuseteil und/oder das zweite Gehäuseteil rohrförmig und/oder von einer Durchgangsöffnung durchdrungen sind.

Beispiel 3 (z.B. eine Schutzvorrichtung) ist eingerichtet gemäß Beispiel 1 oder 2, wobei das zweite Gehäuseteil eingerichtet ist, in das erste Gehäuseteil (z.B. eine Durchgangsöffnung dessen) hinein eingesteckt zu werden, z.B. zu dem Lichtaufnahmebereich hin.

Beispiel 4 (z.B. eine Schutzvorrichtung) ist eingerichtet gemäß einem der Beispiele 1 bis 3, eine erste Dichtvorrichtung, welche den Lichtaufnahmebereich umgibt und/oder abdichtet.

Beispiel 5 (z.B. eine Schutzvorrichtung) ist eingerichtet gemäß einem der Beispiele 1 bis 4, wobei die Montagevorrichtung einen Schlauchanschluss (z.B. Schlauchtülle) aufweist, in welchem ersten Fluidtransferkanal mündet (oder welcher zumindest einen Abschnitt des ersten Fluidtransferkanals bereitstellt) und/oder welcher von dem zweiten Gehäuseteil hervorsteht.

Beispiel 6 (z.B. eine Schutzvorrichtung) ist eingerichtet gemäß einem der Beispiele 1 bis 5, wobei die Montagevorrichtung einen Flansch und/oder ein (z.B. rohrförmiges) Zwischenstück aufweist, in welchen/m der erste und/oder der zweite Fluidtransferkanal münden und/oder eine Durchgangsöffnung aufweisend zum Aufnehmen des Schlauchanschlusses. Dies (z.B. das Zwischenstück) erleichtert die Montage.

Beispiel 7 (z.B. eine Schutzvorrichtung) ist eingerichtet gemäß einem der Beispiele 1 bis 6, wobei die Montagevorrichtung ein (z.B. rohrförmiges) Zwischenstück aufweist, welches einen Flansch und eine dem Flansch gegenüberliegende zweite Dichtvorrichtung zum Ankuppeln an das Überdruckgehäuse (z.B. das erste oder zweite Gehäuseteil) aufweist. Dies (z.B. das Zwischenstück) erleichtert die Montage.

Beispiel 8 (z.B. eine Schutzvorrichtung) ist eingerichtet gemäß einem der Beispiele 1 bis 7, wobei das zweite Gehäuseteil eine Haltevorrichtung aufweist, welche eingerichtet ist, die Erfassungsvorrichtung (z.B. Kamera), vorzugsweise drehgesichert, (z.B. kraftschlüssig und/oder formschlüssig) zu halten.

Beispiel 9 (z.B. eine Schutzvorrichtung) ist eingerichtet gemäß einem der Beispiele 1 bis 8, wobei der erste und/oder der zweite Fluidtransferkanal in den Hohlraum mündet; und/oder wobei der dritte Fluidkanal zwei Abschnitte des Hohlraums (zwischen denen beispielsweise die Haltevorrichtung angeordnet ist) fluidleitend miteinander koppelt, z.B. an der Haltevorrichtung vorbei. Der dritte Fluidkanal begünstigt die Fluidströmung.

Beispiel 10 (z.B. eine Schutzvorrichtung) ist eingerichtet gemäß einem der Beispiele 1 bis 9, wobei das zweite Gehäuseteil eine stirnseitige erste Aussparung aufweist, mittels welcher der erste Fluidtransferkanal bereitgestellt ist, eine nutförmige zweite Aussparung aufweist, mittels welcher der zweite Fluidtransferkanal bereitgestellt ist; und/oder eine nutförmige dritte Aussparung aufweist, mittels welcher der dritte Fluidtransferkanal bereitgestellt ist.

Beispiel 11 (z.B. eine Schutzvorrichtung) ist eingerichtet gemäß einem der Beispiele 1 bis 10, wobei die Montagevorrichtung eine umlaufende Dichtfläche und/oder einen Flansch aufweist.

Beispiel 12 (z.B. eine Schutzvorrichtung) ist eingerichtet gemäß einem der Beispiele 1 bis 11, wobei das erste Gehäuseteil eine erste Vertiefung zum Aufnehmen des zweiten Gehäuseteils aufweist, welche: an die Öffnung angrenzt; zumindest einen Bereich des Hohlraums bereitstellt; und/oder sich zu dem Lichtaufnahmebereich (auch als Lichttransferbereich bezeichnet) hin verjüngt. Dies (z.B. die verjüngende Geometrie) vereinfacht die Konstruktion und Montage.

Beispiel 13 (z.B. ein/eine Schutzvorrichtung) ist eingerichtet gemäß einem der Beispiele 1 bis 12, wobei das zweite Gehäuseteil eine Vertiefung aufweist, in welche der erste Fluidtransferkanal mündet und/oder an welcher vorbei der zweite Fluidkanal verläuft. Dies begünstigt den Fluidfluss und somit die Kühlung. Die Vertiefung kann sich beispielsweise zu der Montagevorrichtung hin verjüngen und/oder zumindest einen Bereich des Hohlraums bereitstellen. Dies (z.B. die verjüngende Geometrie) vereinfacht die Konstruktion und Montage.

Beispiel 14 (z.B. eine Schutzvorrichtung) ist eingerichtet gemäß einem der Beispiele 1 bis 13, ferner aufweisend: eine transparente Wand (z.B. Platte, z.B. Scheibe) aufweist, welche vorzugsweise an der ersten Dichtvorrichtung anliegt und/oder zumindest einen Abschnitt des Lichtaufnahmebereichs bereitstellt.

Beispiel 15 (z.B. eine Schutzvorrichtung) ist eingerichtet gemäß einem der Beispiele 1 bis 14, ferner aufweisend: eine Abdeckklappe, welche beweglich (z.B. mittels eines Drehlagers) gelagert ist, so dass der Lichtaufnahmebereich, wenn die Abdeckklappe in einen ersten Zustand (z.B. Position) gebracht ist, von der Abdeckklappe abgedeckt wird, und, wenn die Abdeckklappe in einen zweiten Zustand (z.B. Position) gebracht ist, freigelegt ist.

Beispiel 16 (z.B. eine Schutzvorrichtung) ist eingerichtet gemäß Beispiel 1 bis 15, ferner aufweisend: ein Getriebe, welches eingerichtet ist, eine auf das Getriebe wirkende Kraft in ein Drehmoment zu überführen und das Drehmoment auf die Abdeckklappe zu übertragen. Das Getriebe kann beispielsweise einen oder mehr als einen Hebel und/oder einen Bowdenzug aufweisen.

Beispiel 17 ist ein Erfassungssystem, aufweisend: eine Schutzvorrichtung gemäß einem der Ansprüche 1 bis 16, die Erfassungsvorrichtung, welche in dem Hohlraum aufgenommen ist und/oder mittels der Haltevorrichtung (z.B. drehgesichert) gehalten wird, wobei die Erfassungsvorrichtung beispielsweise eine Kamera (z.B. Endoskop-Kamera) und/oder ein Lichtleiterkabel aufweist.

Beispiel 18 ist ein Verwenden eines der Beispiele 1 bis 17 im Vakuum zum Erfassen optischer Strahlung (zumindest im Vakuum), vorzugsweise zum Erfassen von Bildinformationen, z.B. eines Prozesses (z.B. Beschichtungsprozess) und/oder einer Substrattransferöffnung, z.B. wenn die Schutzvorrichtung dem Prozess und/oder einem Vakuum ausgesetzt ist.

Beispiel 19 (z.B. ein Verwenden) ist eingerichtet gemäß einem der Beispiele 1 bis 18, wobei das Bauteil eine (z.B. optische) Erfassungsvorrichtung aufweist oder daraus besteht, welche beispielsweise eingerichtet ist zum Erfassen optischer Strahlung.

Beispiel 20 ist eingerichtet gemäß einem der Beispiele 1 bis 19, wobei das Bauteil eine Kamera (z.B. einen Endoskop-Kopf) aufweist oder daraus besteht, welche beispielsweise eingerichtet ist zum Erfassen optischer Strahlung.

Beispiel 21 ist eingerichtet gemäß einem der Beispiele 1 bis 20, wobei das Bauteil eingerichtet ist zum Erfassen elektromagnetischer (z.B. optischer) Strahlung, z.B. in einem Wellenlängenbereich von ungefähr 10E-8 m bis ungefähr 10E-5 m.

Beispiel 22 ist eine Vakuumanordnung, aufweisend: eine Vakuumkammer, in welcher die Schutzvorrichtung gemäß einem der Beispiele 1 bis 21 angeordnet ist.

Beispiel 23 ist eingerichtet gemäß einem der Beispiele 1 bis 22, wobei die Erfassungsvorrichtung einen oder mehr als einen optischen Sensor aufweist.

Beispiel 24 ist eingerichtet gemäß einem der Beispiele 1 bis 23, wobei eine Temperatur (auch als Betriebstemperatur bezeichnet), welcher die Schutzvorrichtung im Betrieb ausgesetzt ist, größer ist als 100°C (z.B. als 200°C oder als 300°C).

Beispiel 25 ist eingerichtet gemäß einem der Beispiele 1 bis 24, wobei eine chemische Zusammensetzung einer Atmosphäre (auch als Prozessatmosphäre bezeichnet), welcher die Schutzvorrichtung im Betrieb ausgesetzt ist, ein Metall, einen Halbleiter und/oder ein Übergangsmetall aufweist.

Beispiel 26 ist eingerichtet gemäß einem der Beispiele 1 bis 25, wobei die Schutzvorrichtung im Betrieb einem Vakuum ausgesetzt ist.

Beispiel 27 ist eingerichtet gemäß einem der Beispiele 1 bis 26, wobei die Schutzvorrichtung im Betrieb einem Beschichtungsprozess ausgesetzt ist.

Beispiel 28 ist eingerichtet gemäß einem der Beispiele 1 bis 27, wobei die Schutzvorrichtung im Betrieb einem Material ausgesetzt ist, mit dem die Schutzvorrichtung beschichtet wird.

Beispiel 29 ist eingerichtet gemäß einem der Beispiele 1 bis 28, wobei die Erfassungsvorrichtung und/oder der Aufnahmeraum im Betrieb einem Fluid, z.B. einer Flüssigkeit, ausgesetzt sind, welches beispielsweise durch den einen oder mehr als einen Fluidkanal hindurch strömt.

Beispiel 30 ist eingerichtet gemäß einem der Beispiele 1 bis 29, wobei die Erfassungsvorrichtung eingerichtet ist zum Erfassen einer Wellenlänge oder eines Spektralbereichs, für welchen der Lichtaufnahmebereich transparent ist. Beispiel 31 ist eingerichtet gemäß einem der Beispiele 1 bis 30, (z.B. die Erfassungsvorrichtung) ferner aufweisend: eine (z.B. mehrteilige und/oder hermetisch separierende) Einhäusung (z.B. ein oder mehr als ein drittes Gehäuseteil aufweisend), welche eingerichtet ist, in dem Hohlraum aufgenommen zu werden und einen optischen Sensor (oder eine Kamera) einzuhäusen (z.B. wasserdicht einzuhäusen), die Einhäusung vorzugsweise aufweisend.

Beispiel 32 ist eingerichtet gemäß einem der Beispiele 1 bis 31, (z.B. die Erfassungsvorrichtung, z.B. deren Einhäusung) ferner aufweisend: mehrere dritte Gehäuseteile, welche zusammengefügt einen Hohlraum (auch als Zwischenraum bezeichnet) bilden zum Aufnehmen eines optischen Sensors (oder eine Kamera) und/oder eine zusätzliche (z.B. zumindest teilweise transparente) Lichtaufnahmewand, welche den Zwischenraum begrenzt und, wenn die dritten Gehäuseteile in dem Aufnahmeraum angeordnet sind, dem Lichtaufnahmebereich zugewandt ist.

Beispiel 33 ist eingerichtet gemäß einem der Beispiele 1 bis 32, (z.B. die Erfassungsvorrichtung, z.B. deren Einhäusung) ferner aufweisend: eine Durchführung (z.B. Kabeldurchführung), welche eingerichtet ist, einen Schlauch (z.B. des Kabels) aufzunehmen (z.B. abdichtend aufzunehmen), wobei die Durchführung beispielsweise eine Dichtvorrichtung (z.B. eine Ringdichtung aufweisend) aufweist. Der Schlauch kann beispielsweise eine elektrische Ummantelung des Kabels bereitstellen oder zum Aufnehmen des Kabels eingerichtet sein.

Beispiel 34 ist eingerichtet gemäß einem der Beispiele 1 bis 33, (z.B. die Erfassungsvorrichtung) ferner aufweisend: einen optischen Sensor und eine Leiterplatte, welche den Sensor mit einem Kabel (z.B. deren elektrischen Leitern) kommunikativ koppelt. Ferner kann die Erfassungsvorrichtung beispielsweise einen (z.B. starren) Träger aufweisen, an welchem die Leiterplatte und/oder der Sensor montiert sind.

Beispiel 35 ist eingerichtet gemäß einem der Beispiele 1 bis 34, wobei das zweite Gehäuseteil eingerichtet ist, in das erste Gehäuseteil hinein eingesteckt zu werden (z.B. entlang einer Richtung, z.B. Erfassungsrichtung), und/oder wobei das erste Gehäuseteil eine Vertiefung aufweist, die sich vorzugsweise entlang der Richtung (z.B. Erfassungsrichtung) in das erste Gehäuseteil hinein erstreckt, zum Aufnehmen des zweiten Gehäuseteils.

Beispiel 36 ist eingerichtet gemäß einem der Beispiele 1 bis 35, wobei der transparenten Lichtaufnahmebereich entlang einer Richtung (z.B. Erfassungsrichtung) an den Hohlraum angrenzt; und/oder wobei der erste Fluidtransferkanal entlang der Richtung (z.B. Erfassungsrichtung) in dem Hohlraum mündet.

Beispiel 37 ist eingerichtet gemäß einem der Beispiele 1 bis 36, wobei der Lichtaufnahmebereich der Montagevorrichtung entlang einer Richtung (z.B. Erfassungsrichtung) gegenüberliegend angeordnet ist.

Beispiel 38 ist eingerichtet gemäß einem der Beispiele 1 bis 37, wobei: der zweite Fluidtransferkanal (z.B. entlang der Richtung) eine größere Ausdehnung (z.B. Länge) aufweist als der erste Fluidtransferkanal (zumindest um mehr als das Doppelte, z.B. Dreufache, der Ausdehnung dessen) und/oder der zweite Fluidtransferkanal (z.B. entlang der Richtung) an einem oder mehr als einem vorbei erstreckt ist: einer Mündung des ersten Fluidtransferkanals in dem Hohlraum und/oder einem Abschnitt des Hohlraums (in den der erste Fluidtransferkanal beispielsweise mündet).

Beispiel 39 ist eingerichtet gemäß einem der Beispiele 1 bis 38, wobei der Hohlraum einen Abschnitt aufweist, welcher den ersten Fluidtransferkanal und den zweiten Fluidtransferkanal voneinander separiert (in welchen diese vorzugsweise einmünden); und/oder wobei der Abschnitt eine Ausdehnung (z.B. Länge und/oder entlang der Richtung) aufweist, die größer ist als eines oder mehr als eines von Folgendem: eine Ausdehnung (z.B. Breite) des Hohlraums quer zu der Richtung; die Ausdehnung des ersten Fluidtransferkanal (z.B. entlang der Richtung).

Beispiel 40 ist eingerichtet gemäß einem der Beispiele 1 bis 39, wobei das Überdruckgehäuse eingerichtet ist, einem Überdruck in dem Hohlraum aufzunehmen (z.B. bezogen auf einen äußeren Druck, dem das Überdruckgehäuse ausgesetzt ist). Der Überdruck weist beispielsweise eine Differenz von dem äußeren Druck von mehr als 0,1 (z.B. 0,5) bar, z.B. mehr als 0,9 bar, auf

Beispiel 41 ist eingerichtet gemäß einem der Beispiele 1 bis 40, wobei das Überdruckgehäuse formstabil eingerichtet ist, gegenüber einem Überdruck in dem Hohlraum (z.B. bezogen auf einen äußeren Druck, dem das Überdruckgehäuse ausgesetzt ist). Der Überdruck weist beispielsweise eine Differenz von dem äußeren Druck von mehr als 0,1 (z.B. 0,5) bar, z.B. mehr als 0,9 bar, auf.

Beispiel 42 ist eingerichtet gemäß einem der Beispiele 1 bis 41, wobei der erste Fluidtransferkanal und der zweite Fluidtransferkanal eingerichtet sind, ein Fluid durch den Hohlraum (z.B. dessen Abschnitt) hindurch zu führen und/oder das Fluid mittels des Hohlraum (z.B. dessen Abschnitt) miteinander auszutauschen.

Beispiel 43 ist eingerichtet gemäß einem der Beispiele 1 bis 42, wobei das erste Gehäuseteil und/oder das zweite Gehäuseteil metallisch sind und/oder zumindest ein Metall aufweisen, z.B. daraus bestehen.

Beispiel 44 ist eingerichtet gemäß einem der Beispiele 1 bis 43, wobei das erste Gehäuseteil und/oder das zweite Gehäuseteil (z.B. chemisch und/oder mechanisch) stabil sind für eine Temperatur von 150°C oder mehr, z.B. 200°C oder mehr, z.B. 300°C oder mehr, z.B. 500°C oder mehr.

Es zeigen
Figur 1A, 1B jeweils eine Schutzvorrichtung gemäß verschiedenen Ausführungsformen in verschiedenen schematischen Ansichten;
Figur 2A und B jeweils ein Erfassungssystem gemäß verschiedenen Ausführungsformen in verschiedenen schematischen Ansichten;
Figur 3A ein Versorgungssystem des Erfassungssystems gemäß verschiedenen Ausführungsformen in einer schematischen Seitenansicht oder Querschnittsansicht;
Figur 3B und 4A jeweils eine Vakuumanordnung gemäß verschiedenen Ausführungsformen in verschiedenen schematischen Ansichten;
Figur 4B und 5A jeweils eine Vakuumanordnung gemäß verschiedenen Ausführungsformen in verschiedenen schematischen Ansichten;
Figur 5B ein Schlauchsystem gemäß verschiedenen Ausführungsformen in einer schematischen Querschnittsansicht; Figur 6 eine Schutzvorrichtung gemäß verschiedenen Ausführungsformen einer schematischen Ansicht; und
Figur 7A und B jeweils ein Erfassungssystem gemäß verschiedenen Ausführungsformen in verschiedenen schematischen Ansichten.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert. Der Ausdruck 10Ex (wobei x eine Zahl ist) drückt den Wert 10× (10 hoch x) aus.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung ausgetauscht werden kann, z.B. ein Fluid (dann auch als fluidleitend gekoppelt bezeichnet). Beispielsweise können zwei miteinander gekoppelte Elemente eine Wechselwirkung miteinander austauschen, z.B. eine mechanische, hydrostatische, thermische und/oder elektrische Wechselwirkung. Eine Kopplung mehrerer Vakuumkomponenten (z.B. Ventilen, Pumpen, Kammern, usw.) miteinander kann aufweisen, dass diese fluidleitend miteinander gekoppelt sind. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Der Begriff "Vakuumdruck" bezeichnet hierin einen Unterdruck im Bereich des Vakuums (d.h. ein Druck von weniger als 0,3 bar), z.B. ein Druck in einem Bereich von ungefähr 10 mbar bis ungefähr 1 mbar (mit anderen Worten Grobvakuum) bereitgestellt werden kann oder weniger, z.B. ein Druck in einem Bereich von ungefähr 1 mbar bis ungefähr 10⁻³ mbar (mit anderen Worten Feinvakuum) oder weniger, z.B. ein Druck in einem Bereich von ungefähr 10⁻³ mbar bis ungefähr 10⁻⁷ mbar (mit anderen Worten Hochvakuum) oder weniger, z.B. ein Druck von kleiner als Hochvakuum, z.B. kleiner als ungefähr 10⁻⁷ mbar (auch als 10E-7 mbar bezeichnet).

Als Hohlraum kann hierin beispielsweise eine zusammenhängende Kavität verstanden werden, welche frei ist von einem festen Material. Der Hohlraum kann beispielsweise mit einem Fluid gefüllt sein, z.B. einer Flüssigkeit und/oder eines Gases.

Gemäß verschiedenen Ausführungsformen kann die Vakuumkammer mittels eines Kammergehäuses (auch als Vakuumkammergehäuse bezeichnet) bereitgestellt sein oder werden, in dem eine Kammer oder mehrere Kammern bereitgestellt sein oder werden können. Das Vakuumkammergehäuse kann beispielsweise zum Bereitstellen eines Unterdrucks oder eines Vakuums mit einer Pumpenanordnung, z.B. einer Vakuumpumpenanordnung, (z.B. gasleitend) gekoppelt sein und derart stabil eingerichtet sein, dass diese dem Einwirken des Luftdrucks im abgepumpten Zustand (wenn darin ein Vakuumdruck bereitgestellt ist) standhält. Dies gilt in Analogie für die Dichtungen. Die Pumpenanordnung (aufweisend zumindest eine Vakuumpumpe, z.B. eine Hochvakuumpumpe, z.B. eine Turbomolekularpumpe) kann es ermöglichen, einen Teil des Gases aus dem Inneren der Prozessierkammer, z.B. aus dem Prozessierraum, abzupumpen. Dementsprechend kann eine Vakuumkammer oder können mehrere Vakuumkammern in einem Vakuumkammergehäuse bereitgestellt sein. Ferner wird eine zum Prozessieren eingerichtete Vakuumkammer auch als Prozessierkammer bezeichnet, z.B. im Fall des Beschichtens als eine exemplarisches Prozessieren als Beschichtungskammer.

Gemäß verschiedenen Ausführungsformen kann eine Überdruckkammer mittels eines Kammergehäuses (auch als Überdruckkammergehäuse bezeichnet) bereitgestellt sein oder werden, in dem eine Kammer oder mehrere Kammern bereitgestellt sein oder werden können. Das Überdruckkammergehäuse kann beispielsweise zum Bereitstellen eines Überdrucks derart stabil eingerichtet sein, dass diese dem Einwirken des Überdrucks im Inneren der Kammer standhält. Beispielsweise kann das Überdruckkammergehäuse, in dem ein Luftdruck bereitgestellt ist, in einem Vakuum angeordnet sein, so dass der Luftdruck gegenüber dem Vakuum als Überdruck wirkt. Als Luftdruck wird der hydrostatische Druck der Erdatmosphäre am Ort der Überdruckkammer verstanden.

Als Sensor (auch als Detektor bezeichnet), kann ein Wandler verstanden werden, der eingerichtet ist, eine zu dem Sensortyp korrespondierende Eigenschaft seiner Umgebung qualitativ oder als Messgröße quantitativ zu erfassen, z.B. eine physikalische oder chemische Eigenschaft und/oder eine stoffliche Beschaffenheit. Die Messgröße ist diejenige physikalische Größe, der die Messung mittels des Sensors gilt. Je nach Komplexität des zu messenden Umgebung des Sensors kann der Sensor eingerichtet sein, nur zwischen zwei Zuständen der Messgröße unterscheiden zu können (auch als Messschalter bezeichnet), zwischen mehr als zwei Zuständen der Messgröße unterscheiden zu können oder die Messgröße quantitativ zu erfassen. Der Messschalter kann beispielsweise unterscheiden, ob die Messgröße ein Kriterium erfüllt (z.B. einen Schwellenwert überschreitet oder unterschreitet) oder das Kriterium nicht erfüllt. Ein Beispiel für einen Messschalter ist ein Drucksensor, der eingerichtet ist, zu erfassen, ob ein Druck als Messgröße ein Unterdruck ist oder nicht. Ein anderes Beispiel für einen Messschalter ist ein Füllstandssensor sein, der eingerichtet ist, zu erfassen, ob ein Füllstand als Messgröße den Ort des Sensors erreicht hat ist oder nicht, z.B. indem dieser erfasst, ob dieser in Kontakt mit Wasser ist oder nicht. Ein Beispiel für eine quantitativ erfasste Messgröße ist beispielsweise eine Fluidflussrate (z.B. Durchflussrate), deren Ist-Zustand mittels des Sensors als Wert erfasst werden kann.

Ein Sensor kann Teil einer Messkette sein, welche eine entsprechende Infrastruktur (z.B. Prozessor, Speichermedium und/oder Bussystem oder dergleichen aufweisend) aufweist. Die Messkette kann eingerichtet sein, den entsprechenden Sensor (z.B. Wassersensor, Drucksensor und/oder optischer Sensor) anzusteuern, dessen erfasste Messgröße als Eingangsgröße zu verarbeiten und darauf basierend ein elektrisches Signal als Ausgangsgröße bereitzustellen, welches die Eingangsgröße repräsentiert. Die Messkette kann beispielsweise mittels der Steuervorrichtung implementiert sein oder werden.

Eine Erfassungsvorrichtung (auch als Sensorvorrichtung oder als Messglied bezeichnet) weist hierin, beispielsweise pro Messgröße der Erfassungsvorrichtung, einen oder mehr als einen Sensor (z.B. Bilderfassungssensor) auf, der eingerichtet ist, einen oder mehr als einen Messgröße (z.B. Wellenlänge und/oder Intensität elektromagnetischer Strahlung) der Erfassungsvorrichtung zu erfassen, und/oder einen Messbereich der Messgröße abzudecken. Die elektromagnetische Strahlung kann einen Wellenlängenbereich aufweisen, der Röntgenstrahlung, UV-Strahlung (A bis C), sichtbares Licht und/oder Infrarot-Strahlung (A bis C) aufweist.

Ein Bilderfassungssensor (auch als Bildsensor oder optischer Sensor bezeichnet) kann einen oder mehrere photoelektrisch aktive Bereiche (kann auch als Pixel bezeichnet werden) aufweisen, welche z.B. in Antwort auf eine elektromagnetische Strahlung (z.B. Licht, z.B. sichtbares Licht) ein elektrisches Signal erzeugen und/oder modifizieren. Der Bilderfassungssensor kann beispielsweise ein CCD-Sensor (charge-coupled device Sensor) und/oder einen aktiven Pixelsensor (kann auch als CMOS-Sensor bezeichnet werden) aufweisen oder daraus gebildet sein. Optional kann ein Bilderfassungssensor wellenlängensensitiv eingerichtet sein (z.B. zum Erfassen von Farbinformationen), z.B. mittels mehrerer Farbfilter (z.B. in Gitterform).

Transparent wird hierin verstanden als einen Transmissionskoeffizient von mehr als 50% aufweisend, z.B. für die elektromagnetische Strahlung (z.B. für eine Wellenlänge von 550 Nanometer) und/oder mehr als 75%, z.B. 90%. Eine Endoskop-Kamera weist ein (z.B. flexibles oder starres) Kabel und einen sogenannten Kopf (auch als Endoskop-Kopf bezeichnet) auf, welcher eine Lichtquelle und eine Kamera aufweist. Der Endoskop-Kopf kann beispielsweise ein wasserdichtes Gehäuse aufweisen, in welchem die Lichtquelle und die Kamera angeordnet sind und/oder welches wasserdicht mit einer Ummantelung des Kabels verbunden ist. Die Kamera weist beispielsweise einen Bilderfassungssensor und eine vorgelagerte Optik (z.B. eine oder mehr als eine Linse aufweisend) auf.

Hierin wird Bezug genommen auf ein mehrteiliges Gehäuse (z.B. Überdruckgehäuse), welches mehrere Komponenten (auch als Gehäuseteile bezeichnet) aufweist, die zu dem Gehäuse zusammengefügt werden können. Das Gehäuse weist einen Aufnahmeraum auf, welcher zumindest abschnittsweise von einem oder mehr als einem der Gehäuseteile bereitgestellt werden kann. Beispielsweise kann ein Gehäuseteil eine Aussparung (z.B. Durchgangsöffnung) aufweisen, welche zumindest einen Abschnitt des Aufnahmeraums bereitstellt. Alternativ oder zusätzlich kann die Aussparung eingerichtet sein, eines der anderen Gehäuseteile aufzunehmen. Die mehreren Gehäuseteile können ein oder mehr als ein wandbildendes Gehäuseteil aufweisen, welche eine Wand des Gehäuses (auch als Gehäusewand bezeichnet), z.B. zumindest einen Abschnitt der Gehäusewand, bereitstellt. Zwei ineinander gesteckte Gehäuseteile können einander berühren, z.B. mit ihren Oberflächen. Beispielsweise kann eines der Gehäuseteile eine Außenfläche aufweisen, welche an einer Innenfläche eines anderen der Gehäuseteile anliegt, wenn das Gehäuse zusammengefügt ist.

Als Montagevorrichtung wird hierin eine Vorrichtung verstanden, welche zum Montieren eingerichtet ist, beispielsweise zum Montieren an einer dazu komplementären Montagevorrichtung (auch als Gegen-Montagevorrichtung bezeichnet). Beim Montierens erfolgt ein (z.B. starres) Verbinden mehrerer Komponenten miteinander mittels ihrer Montagevorrichtungen. Das Montieren kann (beispielsweise ausschließlich) formschlüssig und/oder lösbar erfolgen. Die Montagevorrichtung kann vorzugsweise eine (z.B. planare) Montagefläche aufweisen, welche beim Montieren an einer dazu komplementären Montagefläche der Gegen-Montagevorrichtung anliegt und/oder eine Dichtung bereitstellt. Die Montagevorrichtung kann beispielsweise ein oder mehr als ein (z.B. integrales) Montageprofil (z.B. Formschlussprofil) aufweisen, welches beispielsweise mittels einer Unebenheit (z.B. Vorsprung oder Vertiefung) der Montagevorrichtung bereitgestellt ist. Beispiele für das Montageprofil weisen auf: ein Gewinde, eine Nut (z.B. zur Passfederaufnahme und/oder Schwalbenschwanznut), eine Rastnase, ein Bajonettverschluss, ein Zapfen, usw. Beispiele für die Unebenheit weisen auf: eine Öffnung (z.B. Durchgangsöffnung und/oder Gewindebohrung), ein Bolzen (z.B. ein Gewindebolzen).

Eine exemplarische Implementierung der Montagevorrichtung ist als Flansch eingerichtet, z.B. als Vakuumflansch. Der Flansch kann zum starren und/oder lösbaren Verbinden mit einem anderen Flansch eingerichtet sein. Zwei miteinander verbundene Flansche bilden eine sogenannte Flanschverbindung. Der Flansch kann eine (z.B. planare) Montagefläche aufweisen. Optional kann der Flansch von einer Öffnung (auch als Flanschöffnung bezeichnet) durchdrungen sein, welche von der Montagefläche umgeben wird, z.B. entlang eines in sich geschlossenen Pfades. Die Flanschverbindung kann aufweisen, dass zwei Flansche mit ihren Montageflächen einander zugewandt angeordnet sind, z.B. einander berührend und/oder gegeneinander gepresst. Die Flanschöffnung eines Gehäuses kann in dem Gehäuseinnenraum des Gehäuses münden, z.B. an diesen angrenzend. Optional kann der Flansch eine Nut aufweisen, welche die Flanschöffnung umgibt, z.B. entlang des in sich geschlossenen Pfades die Flanschöffnung umlaufend, und/oder an die Montagefläche, angrenzt. In der Nut kann optional eine Dichtung aufgenommen sein oder werden, wofür Beispiele aufweisen: eine Ringdichtung, eine Metalldichtung und/oder eine Kunststoffdichtung. Optional kann der Flansch einen kragenförmigen Vorsprung aufweisen, der die Montagefläche aufweist. Beispielsweise kann die Montagefläche hervorstehen.

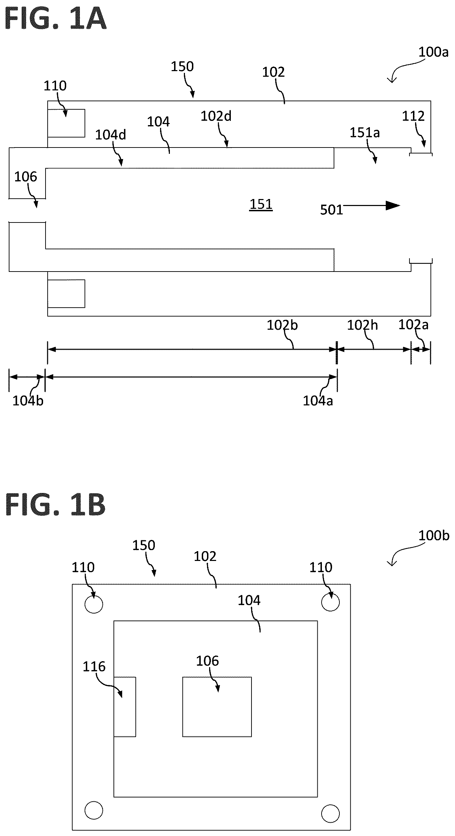

**Fig.1A** veranschaulicht eine Schutzvorrichtung gemäß verschiedenen Ausführungsformen 100a in einer schematischen Seitenansicht oder Querschnittsansicht, beispielsweise eingerichtet gemäß Beispiel 1 und/oder verwendet gemäß Beispiel 18. Die Schutzvorrichtung weist zwei entlang Richtung 501 (auch als Erfassungsrichtung bezeichnet) ineinander steckbare Gehäuseteile auf, welche zusammengesteckt ein Überdruckgehäuse 150 bilden, in welchem der Aufnahmeraum 151 bereitgestellt ist. Die zwei Gehäuseteile 102, 104 weisen ein erstes Gehäuseteil 102 (auch als Außenteil 102 bezeichnet) und ein zweites Gehäuseteil 104 (auch als Innenteil 104 bezeichnet) auf. Eine exemplarische Implementierung des Außenteils 102 (vorzugsweise gemäß Beispiel 2) weist ein Rohr auf oder besteht daraus. Alternativ oder zusätzlich ist das Außenteil 102 (z.B. das Rohr) entlang einer Erfassungsrichtung 501 von einer Durchgangsöffnung 102d (auch als Außenöffnung bezeichnet) durchdrungen, welche beispielsweise sich verjüngende Vertiefung bereitstellt. Das Außenteil 102 weist eine oder mehr als eine Gehäusewand auf, welche die Außenöffnung 102d begrenzt. Beispielsweise weist das Außenteil 102 eine erste Stirnseite und/oder eine der ersten Stirnseite gegenüberliegende zweite Stirnseite auf, an welcher die Außenöffnung 102d freiliegt.

Eine exemplarische Implementierung des Innenteils 104 (vorzugsweise gemäß Beispiel 3) ist eingerichtet, in die Aufnahmeöffnung 102d hinein gesteckt zu werden, z.B. in die Erfassungsrichtung 501. Das Innenteil 104 (vorzugsweise gemäß Beispiel 2) weist beispielsweise ein Rohr auf oder besteht daraus. Alternativ oder zusätzlich ist das Innenteil 104 (z.B. das Rohr) entlang der Erfassungsrichtung 501 von einer Durchgangsöffnung 104d (auch als Innenöffnung bezeichnet) durchdrungen, welche beispielsweise einen Fluidkanal 106 und/oder eine sich verjüngende Vertiefung bereitstellt. Das Innenteil 104 weist eine oder mehr als eine Gehäusewand auf, welche die Innenöffnung 102d begrenzt. Beispielsweise weist das Innenteil 104 eine erste Stirnseite und/oder eine der ersten Stirnseite gegenüberliegende zweite Stirnseite auf, an welcher die Außenöffnung 102d freiliegt.

Eine exemplarische Implementierung der Außenöffnung 102d weist mehrere entlang der Erfassungsrichtung 501 hintereinander angeordnet Abschnitte auf, wovon ein erster Abschnitt 102a (auch als stirnseitige Schauöffnung bezeichnet) den transparenten Lichtaufnahmebereich 112 zumindest teilweise bereitstellt, ein zweiter Abschnitt 102b das Innenteil 104 aufnimmt und ein optionaler dritter Abschnitt 102h (auch als Überlaufabschnitt bezeichnet) einen Bereich des Aufnahmeraums 151 bereitstellt.

Eine exemplarische Implementierung der Innenöffnung 104d weist mehrere entlang der Erfassungsrichtung 501 hintereinander angeordnet Abschnitte auf, wovon ein erster Abschnitt 104a einen Bereich des Aufnahmeraums 151 bereitstellt (und im montierten Zustand beispielsweise dem Lichtaufnahmebereich 112 zugewandt ist) und ein zweiter Abschnitt 104b einen (z.B. inneren) Fluidtransferkanal 106 zumindest abschnittsweise bereitstellt.

Eine exemplarische Implementierung des transparenten Lichtaufnahmebereichs 112 weist die stirnseitige Schauöffnung 102a auf. Alternativ oder zusätzlich weist der Lichtaufnahmebereich 112 eine transparente Gehäusewand (nicht dargestellt, auch als Lichtaufnahmewand) oder zumindest einen Abschnitt dieser auf. Die Lichtaufnahmewand weist beispielsweise Glas und/oder eine Platte auf oder besteht daraus. Die Lichtaufnahmewand kann beispielsweise die Schauöffnung 102a begrenzen oder zumindest abdecken. Zwischen der Lichtaufnahmewand und dem Außenteil 102 kann optional eine Dichtvorrichtung (auch als Lichtaufnahmedichtung bezeichnet) angeordnet sein. Die Lichtaufnahmewand und/oder die Lichtaufnahmedichtung können beispielsweise in einer Aussparung des Außenteils 102 aufgenommen sein.

Eine exemplarische Implementierung der Fluid-Montagevorrichtung 110 weist einen oder mehr als einen Flansch auf, welcher beispielsweise eine oder mehr als eine Montageöffnung und/oder eine Dichtvorrichtung aufweist. Die Montagevorrichtung 110 (oder zumindest ein Flansch dieser) kann monolithisch mit dem Außenteil 102 verbunden sein oder formschlüssig daran montiert (z.B. geklemmt und/oder geschraubt) sein, wie nachfolgend genauer erläutert wird. Alternativ oder zusätzlich kann die Montagevorrichtung 110 mehrteilig sein.

**Fig.1****B** veranschaulicht eine Schutzvorrichtung gemäß verschiedenen Ausführungsformen 100b in einer schematischen Seitenansicht oder Querschnittsansicht mit Blick entlang der Erfassungsrichtung 501, z.B. eingerichtet gemäß den Ausführungsformen 100a und/oder gemäß Beispiel 1.

Eine exemplarische Implementierung der Schutzvorrichtung weist einen ersten Fluidtransferkanal 106 (auch als innerer Fluidtransferkanal 106 bezeichnet) auf, der in dem zweiten Abschnitt 104b der Innenöffnung 104d mündet und/oder entlang der Erfassungsrichtung 501 erstreckt ist. Alternativ oder zusätzlich weist die Schutzvorrichtung einen zweiten Fluidtransferkanal 116 (auch als äußerer Fluidtransferkanal 116 bezeichnet) auf, der an eine Innenfläche des Außenteils 102 angrenzt, an welcher das Innenteil 104 anliegt, und/oder in dem Überlaufabschnitt 102h mündet und/oder entlang der Erfassungsrichtung 501 erstreckt ist.

Beispielsweise können das Innenteil 104 und/oder das Außenteil 102 eine Nut als (z.B. kanalförmige) Aussparung aufweisen, welche den zweiten Fluidtransferkanal 116 bereitstellt und/oder entlang der Erfassungsrichtung 501 erstreckt ist. Beispielsweise kann die Nut zwischen der Außenwand des Innenteils 104 und der Innenwand des Außenteils 102 gebildet sein, welche zusammengefügt aneinander liegen.

Eine exemplarische Implementierung des zweiten Fluidtransferkanal 116 ist zumindest abschnittsweise mittels einer kanalförmigen Nut des Innenteils 104 bereitgestellt, welche in die Erfassungsrichtung erstreckt ist. Alternativ oder zusätzlich weist das Außenteil 102 eine kanalförmige Nut (nicht dargestellt) auf, welche in die Erfassungsrichtung erstreckt ist, und den zweiten Fluidtransferkanal 116 zumindest teilweise bereitstellt.

Nachfolgend werden exemplarische Aspekte der Schutzvorrichtung, anhand eines Erfassungssystems erläutert, welche die Schutzvorrichtung und eine Erfassungsvorrichtung aufweist, wobei das hierfür Beschriebene in Analogie gelten kann für die Schutzvorrichtung als solche (z.B. wenn diese einzeln bereitgestellt ist).

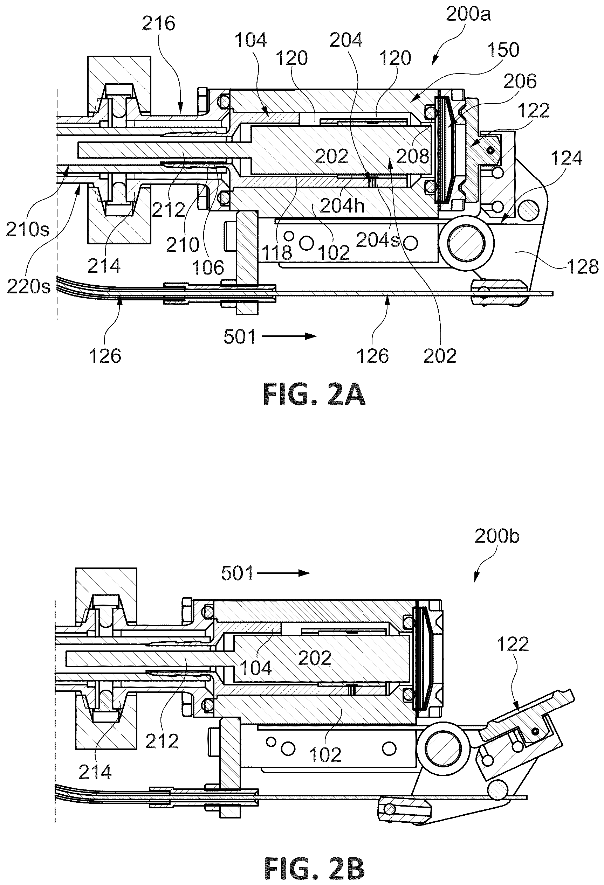

**Fig.2A** veranschaulicht ein Erfassungssystem gemäß verschiedenen Ausführungsformen 200a in einer schematischen Seitenansicht oder Querschnittsansicht, welche die Schutzvorrichtung aufweist, z.B. gemäß einer der Ausführungsformen 100a bis 100b und/oder gemäß Beispiel 1 eingerichtet ist.

Eine exemplarische Implementierung der Erfassungsvorrichtung weist eine Kamera 202 als zylindrischen Endabschnitt (auch als Kopf bezeichnet) auf, welche eingerichtet ist, aus der Erfassungsrichtung 501 stammende optische Strahlung, z.B. Licht, zu erfassen. Die Kamera 202 ist in dem Aufnahmeraum angeordnet und/oder mittels einer Haltevorrichtung 204 (dann auch als Kamera-Haltevorrichtung bezeichnet) montiert. Die Kamera-Haltevorrichtung 204 ist beispielsweise eingerichtet, den Kamerakopf kraftschlüssig zu halten.

Zum vereinfachten Verständnis wird hierin auf die Kamera 202 der Erfassungsvorrichtung Bezug genommen, welche eine besonders kostengünstige Implementierung erlaubt. Es kann verstanden werden, dass die Erfassungsvorrichtung auch einen Lichtleiter aufweisen kann, welcher durch den inneren Fluidtransferkanal aus dem Überdruckgehäuse 150 herausgeführt wird. Der Lichtleiter stellt eine lichtleitende Kopplung der Kamera, die dann nicht notwendigerweise in dem Aufnahmeraum angeordnet sein muss, mit dem Lichtaufnahmebereich bereit. Der Lichtleiter begünstigt eine Annäherung des Lichtaufnahmebereichs an einen Prozess, der beispielsweise einen Betrieb der Kamera stören würde (z.B. aufgrund von Wärme und/oder hochfrequenter elektromagnetischer Strahlung).

Eine exemplarische Implementierung der Kamera-Haltevorrichtung 204 weist eine Klemmschraube 204s und/oder eine Haltehülse 204h auf. Die Klemmschraube 204s kann beispielsweise in einer Gewindebohrung in dem Innenteil 104 aufgenommen sein, welche in dem erster Abschnitt 104a der Innenöffnung 104d mündet. Die Haltehülse 204h ist beispielsweise in dem ersten Abschnitt 104a der Innenöffnung 104d angeordnet, wobei die Kamera 202 in der Haltehülse angeordnet ist und die Klemmschraube gegen die Haltehülse presst, um die Kamera 202 kraftschlüssig zu montieren.

Die Haltehülse 204h schont die Kamera 202, kann aber auch weggelassen werden. Alternativ oder zusätzlich stellt die Haltehülse 204h einen Spalt 118 zwischen der Erfassungsvorrichtung (z.B. Kamera) und der Innenfläche des Innenteils 104 bereit, was die Kühlung der Erfassungsvorrichtung begünstigt. Beispielsweise kann mittels der Haltehülse 204h ein Spalt 118 (auch als Fluidspalt bezeichnet) bereitgestellt sein oder werden, welcher zwischen der Erfassungsvorrichtung und der Innenfläche des Innenteils 104 angeordnet ist.

Mittels der kraftschlüssigen Montage der Kamera 202 mittels der Kamera-Haltevorrichtung 204 (vorzugsweise gemäß Beispiel 8), z.B. mittels der Klemmschraube, kann die Kamera 202 drehgesichtert gehalten werden. Alternativ oder zusätzlich können die Kamera-Haltevorrichtung 204 und die Kamera 202 ineinandergreifen, um die Drehsicherung bereitzustellen. Die Drehsicherung arretiert die Ausrichtung und/oder den Ort der Kamera in dem Innenteil 104, so dass die damit erfassten Bildinformationen lagestabil sind.

Ferner weist die Erfassungsvorrichtung ein Kabel 212 (z.B. Kamerakabel) auf welches eine oder mehr als eine elektrische Leitung, z.B. Datenleitung und/oder Stromversorgungsleitung, und/oder ein Lichtleiterkabel aufweist. Das Kabel 212 ragt aus dem Innenteil 104 heraus, z.B. durch den (z.B. inneren) Fluidtransferkanal 106 hindurch.

Eine exemplarische Implementierung (vorzugsweise gemäß Beispiel 5) der ersten Dichtvorrichtung 208 (dann auch als Lichtaufnahmedichtung bezeichnet) weist eine Ringdichtung auf, welche den Lichtaufnahmebereich, oder zumindest die stirnseitige Schauöffnung 102a umgibt. Die Ringdichtung ist in einer Dichtnut des Außenteils 102 aufgenommen, welche den Lichtaufnahmebereich, oder zumindest die stirnseitige Schauöffnung 102a umgibt.

Eine exemplarische Implementierung der transparenten Lichtaufnahmewand ist zumindest abschnittweise mittels eines Schauglases 206 bereitgestellt. Das Schauglas 206 kann formschlüssig in einer Aussparung aufgenommen sein, welche zwischen zwei Montagevorrichtungen des Außenteils 102 (auch als Glas-Montagevorrichtungen bezeichnet) gebildet ist, die beispielsweise einen Rahmen (z.B. Montagerahmen) bilden. Die Glas-Montagevorrichtungen sind eingerichtet, zusammengefügt, das Schauglas 206 gegen die Lichtaufnahmedichtung zu pressen.

Eine exemplarische Implementierung der Fluid-Montagevorrichtung 110 weist eine Schlauchtülle als Schlauchanschluss 210 auf. Der Schlauchanschluss 210 steht entgegen der Erfassungsrichtung 501 von dem Innenteil 104 hervor und weist einen Hohlraum (auch als Anschlusshohlraum bezeichnet) auf, welcher einen Abschnitt des inneren Fluidtransferkanals 106 bereitstellt oder an diesen angrenzt. Der Schlauchanschluss 210 kann beispielsweise monolithisch mit dem Innenteil 104 verbunden sein, muss dies aber nicht notwendigerweise (z.B. wenn dieser eingeschraubt ist). Mittels des Schlauchanschlusses 210 (z.B. dessen Anschlusshohlraum) kann im Betrieb ein erster Schlauch 210s (auch als Innenschlauch bezeichnet) mit dem Innenteil 104 und/oder dem inneren Fluidkanal 106 fluidleitend gekoppelt sein. Der Schlauchanschluss 210 kann beispielsweise in den Innenschlauch hinein gesteckt sein.

Die oder eine dazu alternative exemplarische Implementierung der Fluid-Montagevorrichtung 110 (vorzugsweise gemäß Beispiel 6) weist einen Flansch 214 auf, in welchen der innere und/oder der äußere Fluidtransferkanal 106, 116 mündet. Der Flansch 214 weist beispielsweise eine Durchgangsöffnung auf, in welche der Schlauchanschluss 210 hinein ragt. Es kann verstanden werden, dass der Schlauchanschluss 210 optional auch aus dem Flansch 214 hervorstehen kann, was die Montage erleichtern kann.

Um die Montage zu erleichtern kann die Fluid-Montagevorrichtung 110 ein rohrförmiges Zwischenstück 216 aufweisen, dessen dem Innenteil 104 abgewandte Stirnseite den Flansch 214 aufweist. Eine exemplarische Implementierung des Zwischenstücks 216 weist eine dem Innenteil 104 zugewandte erste Dichtvorrichtung und/oder einem dem Außenteil 102 zugewandte zweite Dichtvorrichtung auf, welche beispielsweise eine Dichtnut und eine darin aufgenommene Ringdichtung aufweisen. Die erste Dichtvorrichtung (z.B. die Ringdichtung) kann im Betrieb an dem Innenteil 104 (z.B. einem Flansch davon) anliegen, wenn das Zwischenstück 216 daran befestigt ist. Alternativ oder zusätzlich kann zweite Dichtvorrichtung (z.B. die Ringdichtung) im Betrieb an dem Außenteil 102 (z.B. einem Flansch davon) anliegen, wenn das Zwischenstück 216 daran befestigt ist.

Eine exemplarische Implementierung des Innenschlauchs ist in einem zweiten Schlauch 220s (auch als Außenschlauch bezeichnet) angeordnet, welcher mit dem Flansch 214 verbunden ist, z.B. mittels einer Schelle oder eines anderen Klemmrings.

In dem Fall, dass die Kamera-Haltevorrichtung 204, z.B. deren Haltehülse, den Fluidaustausch zu stark behindert, kann das Innenteil 104 einen dritten Fluidkanal 120 (auch als Überlauf oder Bypass-Kanal bezeichnet) aufweisen, welcher zwei Abschnitte des Aufnahmeraums (z.B. in dem Überlaufabschnitt 102h), zwischen denen die Kamera-Haltevorrichtung 204 angeordnet ist, miteinander koppelt.

Eine exemplarische Implementierung der Abdeckklappe 122 (vorzugsweise gemäß Beispiel 15) weist eine Blende auf und ist drehbar gelagert. Die Abdeckklappe 122 lässt sich in einen ersten Zustand (auch als Geschlossen-Zustand bezeichnet) drehen, in welcher diese den Lichtaufnahmebereich abdeckt. Die Abdeckklappe 122 lässt sich in einen zweiten Zustand (auch als Offen-Zustand bezeichnet) drehen, in welcher der Lichtaufnahmebereich freigelegt ist. Ferner ist die Abdeckklappe 122 mit einer Feder 124 gekuppelt. Die Feder ist eingerichtet die Abdeckklappe 122 gegen das Überdruckgehäuse 150 zu pressen und/oder zumindest eine Rückstellkraft bereitzustellen, welche einer Drehung der Abdeckklappe 122 aus dem Geschlossen-Zustand heraus entgegenwirkt.

Eine exemplarische Implementierung des Getriebes (vorzugsweise gemäß Beispiel 16) weist einen Bowdenzug 126 und/oder einen Hebel 128 auf. Der Bowdenzug 126 kann mittels des Hebels 128 mit der Abdeckklappe 122 gekuppelt sein, so dass eine auf den Bowdenzug 126 übertragene Kraft in eine Drehmoment überführt wird, welches eine Drehung der Abdeckklappe 122 aus dem Offen-Zustand heraus anregt.

**Fig.2B** veranschaulicht das Erfassungssystem gemäß verschiedenen Ausführungsformen 200b in einer schematischen Ansicht, wenn die Abdeckklappe 122 in dem Offen-Zustand gebracht ist, z.B. eingerichtet gemäß den Ausführungsformen 200a und/oder gemäß Beispiel 17.

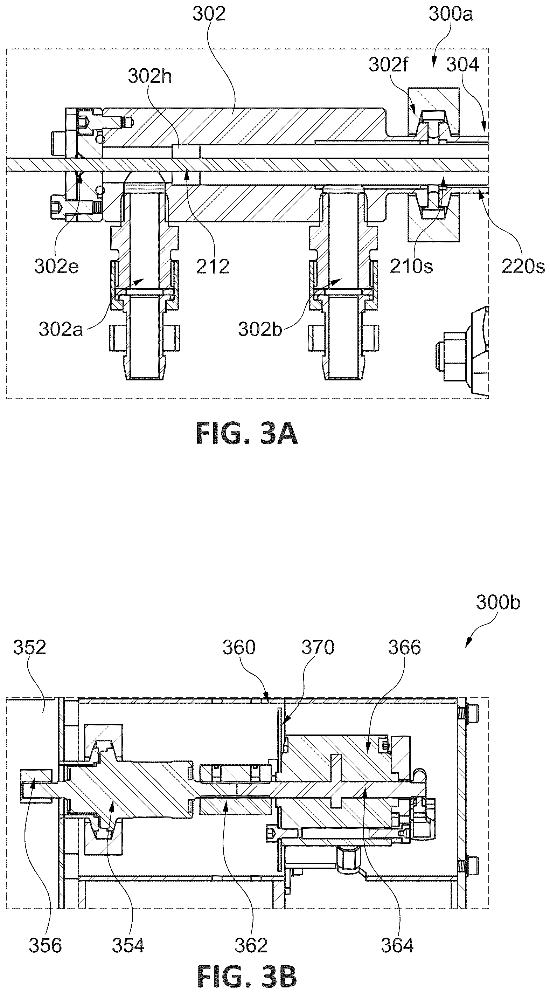

**Fig.3A** veranschaulicht ein Versorgungssystem des Erfassungssystems gemäß verschiedenen Ausführungsformen 300a in einer schematischen Querschnittsansicht, welches mit der Schutzvorrichtung, z.B. eingerichtet gemäß einer der Ausführungsformen 100a bis 200b und/oder gemäß Beispiel 1, gekoppelt sein oder werden kann.

Das Versorgungssystem weist ein Schlauchsystem 304 auf, das den Außenschlauch 220s und den darin angeordneten Innenschlauch 210s aufweist. Ferner weist das Versorgungssystem ein Endstück 302 auf, welches einen ersten Fluidanschluss 302a (auch als Rücklaufanschluss bezeichnet) und einen zweiten Fluidanschluss 302b (auch als Vorlaufanschluss bezeichnet) aufweist und mit dem Schlauchsystem 304 gekuppelt werden kann. Der erste Fluidanschluss 302a ist dann mittels des Innenschlauchs 210s mit dem Aufnahmeraum fluidleitend gekoppelt. Der zweite Fluidanschluss 302b ist dann mittels des Außenschlauchs 220s mit dem Aufnahmeraum fluidleitend gekoppelt.

Eine exemplarische Implementierung des Endstücks 302 weist einen Flansch auf, welcher mit dem Außenschlauch 220s gekuppelt ist, z.B. mittels einer Schelle oder eines anderen Klemmrings. Ferner weist das Endstück 302 einen Hohlraum 302h auf, in welchen der Innenschlauch 210s hinein ragt.

Auf einer dem Flansch 302f gegenüberliegenden Seite weist das Endstück 302 eine Kabeldurchführung 302e auf, welche den Hohlraum begrenzt und eingerichtet ist, das Kabel 312 aufzunehmen, welches in dem Innenschlauch 210s angeordnet ist. Das Kabel 312 ist mittels der Kabeldurchführung 302e (z.B. durch eine Durchgangsöffnung dessen) aus dem Endstück 302 herausgeführt. Ferner weist die Kabeldurchführung 302e eine Dichtung auf, welche gegen das Kabel 212 presst, so dass die Kabeldurchführung 302e fluiddicht ist.

**Fig.3B** veranschaulicht eine Vakuumanordnung gemäß verschiedenen Ausführungsformen 300b (z.B. gemäß Beispiel 22) in einer schematischen Querschnittsansicht, welche die Schutzvorrichtung aufweist, z.B. eingerichtet gemäß einer der Ausführungsformen 100a bis 300a und/oder gemäß Beispiel 1.

Die Vakuumanordnung weist eine Vakuumkammer auf, welche eine Kammerwand 352 aufweist, an welcher eine Drehdurchführung 354 montiert ist. Ferner weist die Vakuumanordnung eine Antriebsvorrichtung 360 auf, welche mittels der Drehdurchführung 354 mit dem Bowdenzug gekuppelt ist. Die Antriebsvorrichtung 360 ist eingerichtet, mittels der Drehdurchführung 354 eine Kraft auf den Bowdenzug zu übertragen.

Eine exemplarische Implementierung der Drehdurchführung 354 ist mittels eines Hebels 356 mit dem Bowdenzug gekuppelt.

Eine exemplarische Implementierung der Antriebsvorrichtung 360 weist eine drehbar gelagerte Welle 364 und eine Wellenkupplung 362 auf, welche die Welle 364 mit der Drehdurchführung 354 kuppelt. Ferner weist die Antriebsvorrichtung 360 eine Drehmomentquelle 366 auf, welche beispielsweise einen pneumatischen Drehantrieb aufweisen kann und eingerichtet ist, ein Drehmoment auf die Welle 364 zu übertragen. Dazu kann die Drehmomentquelle 366 beispielsweise mittels einer Drehmomentstütze 370 drehgesichert an der Vakuumkammer abgestützt sein.

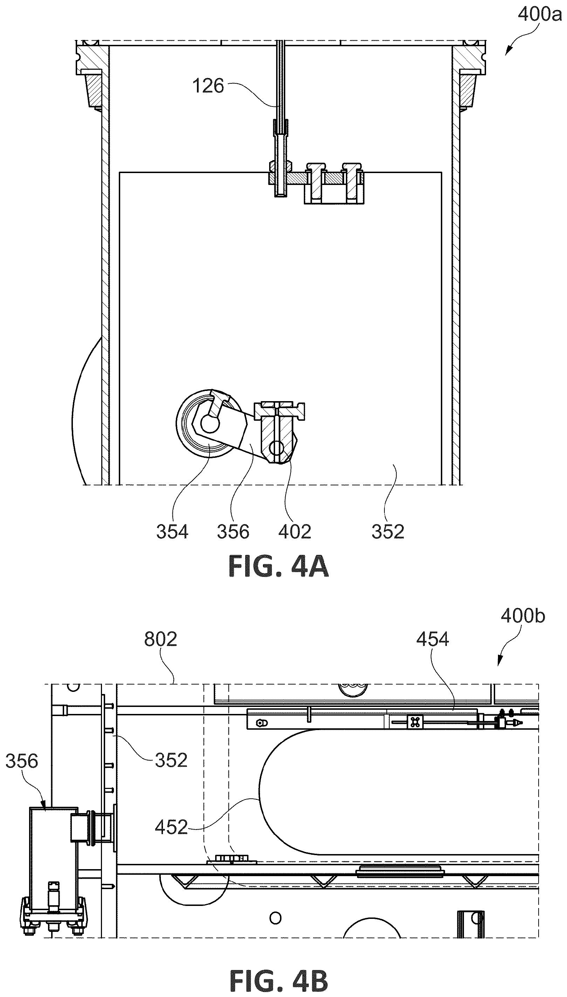

**Fig.4A** veranschaulicht die Vakuumanordnung (z.B. gemäß Beispiel 22) gemäß verschiedenen Ausführungsformen 400a in einer schematischen Seitenansicht mit Blick auf die Kammerwand 352, welche die Schutzvorrichtung aufweist, z.B. eingerichtet gemäß einer der Ausführungsformen 100a bis 300b und/oder gemäß Beispiel 1. Der Bowdenzug 126 kann mittels einer Bowdenzugklemmung 402 mit dem Hebel 356 gekuppelt sein.

**Fig.4B** veranschaulicht die Vakuumanordnung (z.B. gemäß Beispiel 22) gemäß verschiedenen Ausführungsformen 400b in einer schematischen Querschnittsansicht entlang einer Transportrichtung, welche die Schutzvorrichtung aufweist, z.B. eingerichtet gemäß den Ausführungsformen 400a und/oder gemäß Beispiel 1. Die Vakuumanordnung weist eine Transportvorrichtung (nicht dargestellt) auf zum Transportieren eines Substrats entlang der Transportrichtung durch eine Substrattransferöffnung 452 der Vakuumkammer 802 hindurch. Die Erfassungsrichtung 501 (nicht dargestellt) kann auf die Substrattransferöffnung 452 gerichtet sein, was es ermöglicht, zu überwachen, ob ein Substrat in der Substrattransferöffnung angeordnet ist.

Generell ist dieser Bereich der Vakuumkammer nahe der Substrattransferöffnung 452 schwer zugänglich, beispielsweise für einen Überwachungsprozess basierend auf Bildinformationen der Substrattransferöffnung 452. Dies wird gemäß verschiedenen Ausführungsformen erleichtert.

Optional kann die Vakuumanordnung eine Lichtquelle 454 aufweisen, welche eingerichtet ist, Licht in Richtung zu der Substrattransferöffnung zu emittieren. Die Lichtquelle 454 kann beispielsweise über der Substrattransferöffnung angeordnet sind.

Eine exemplarische Implementierung der Lichtquelle 454 weist eine keramische Fassung und eine darin aufgenommene hitzebeständige (d.h. beständig gegenüber der Betriebstemperatur) Glühlampe (z.B. Backofenlampe) auf. Die hitzebeständige Glühlampe ist mittels eines elektrischen Kabels, das eine hitzebeständige Isolierung (z.B. Glasseidenisolierung) aufweist, mit einer elektrischen Durchführung 356 gekoppelt, mittels welcher der Lichtquelle 454 elektrische Leistung zugeführt werden kann.

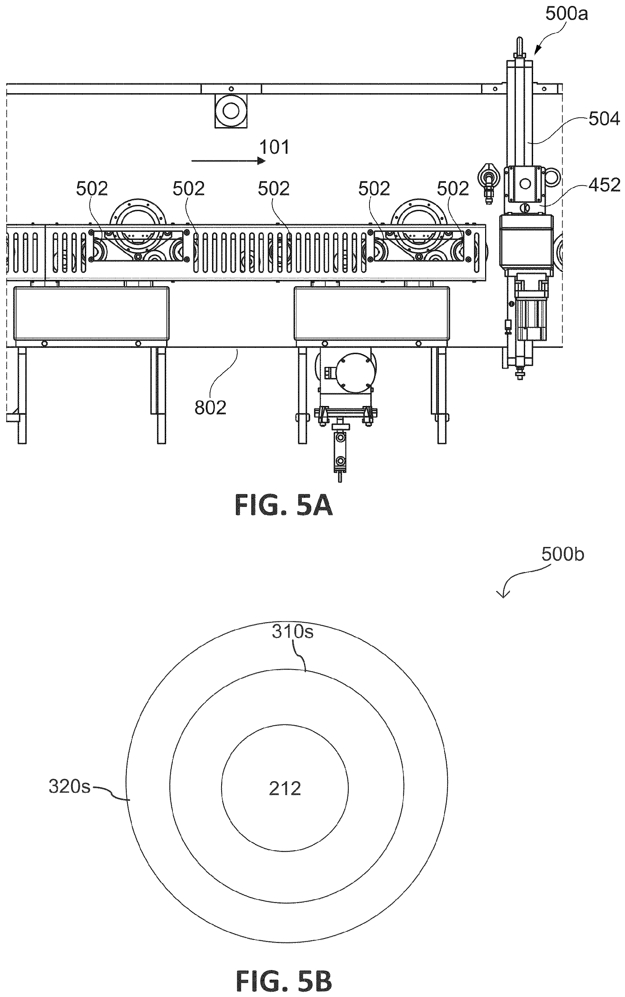

**Fig.5A** veranschaulicht die Vakuumanordnung (z.B. gemäß Beispiel 22) gemäß verschiedenen Ausführungsformen 500b in einer schematischen Seitenansicht mit Blick quer zur Transportrichtung 101, welche die Schutzvorrichtung aufweist, z.B. eingerichtet gemäß einer der Ausführungsformen 100a bis 400b und/oder gemäß Beispiel 1. Die Transportvorrichtung weist eine Vielzahl von Transportrollen 502 auf. Die Vakuumkammer weist eine Ventilklappe 504, mittels welcher sich die Substrattransferöffnung 452 (z.B. vakuumdicht) verschließen lässt, auf welche die Erfassungsrichtung 501 (nicht dargestellt) gerichtet ist.

**Fig.5B** veranschaulicht ein Schlauchsystem gemäß verschiedenen Ausführungsformen 500b in einer schematischen Querschnittsansicht, welches mit der Montagevorrichtung der Schutzvorrichtung gekuppelt ist, die gemäß einer der Ausführungsformen 100a bis 500a und/oder gemäß Beispiel 1 eingerichtet ist. Das Schlauchsystem weist den Außenschlauch 320s und darin angeordnet den Innenschlauch 310s auf. In dem Innenschlauch kann das Kabel 212 angeordnet sein. Im Betrieb können der Außenschlauch 320s und der darin angeordnete Innenschlauch 310s ein Fluid (z.B. eine Kühlflüssigkeit) miteinander austauschen, z.B. mittels des Aufnahmeraums und/oder mittels des Überlaufabschnitts 102h.

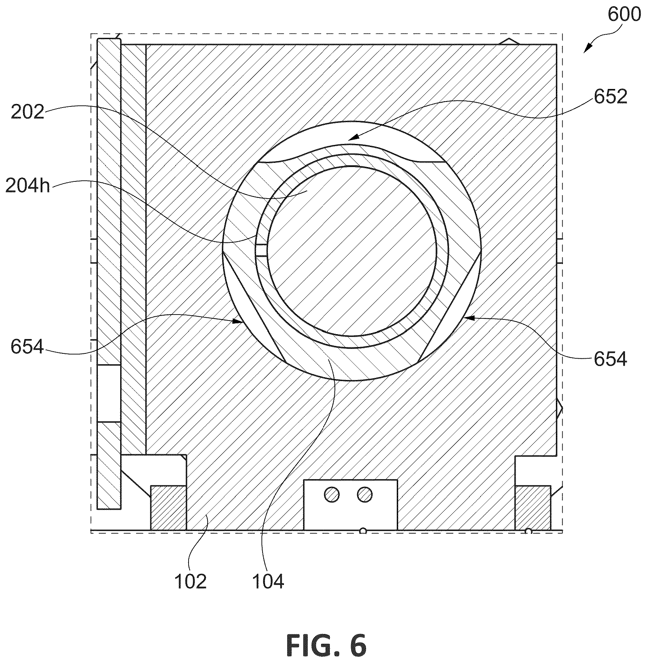

**Fig.6** veranschaulicht eine Schutzvorrichtung gemäß verschiedenen Ausführungsformen 600 in einer schematischen Seitenansicht mit Blick entlang der Erfassungsrichtung 501, welche die Schutzvorrichtung aufweist, z.B. eingerichtet gemäß einer der Ausführungsformen 100a bis 500b und/oder gemäß Beispiel 1. Dargestellt sind eine rohrförmige Haltevorrichtung 204h, eine zylinderförmige Kamera 202 in der Haltevorrichtung 204h und das Innenteil 104, welches mehrere kanalförmige Aussparungen aufweist zum Bereitstellen eines oder mehr als eines Fluidtransferkanals, wovon eine erste Aussparung 652 den Überlauf bereitstellt und jede von zwei zweiten Aussparungen 654 einen äußeren Fluidtransferkanal 116 bereitstellt.

Für den Fall, dass die Erfassungsvorrichtung selbst nicht wasserdicht und/oder zumindest für den Betrieb in Wasser als Fluid ausgelegt ist, kann eine wasserfreie (oder wasserarme) Kühlflüssigkeit (z.B. ein Öl, Alkohol und/oder ein Gas) als Fluid und/oder eine Einhäusung verwendet werden, welche nachfolgend erläutert wird.

Eine exemplarische Implementierung der Einhäusung ist eingerichtet, einen hermetisch separierten und/oder trockenen Innenraum (auch als Zwischenraum bezeichnet) bereitzustellen, beispielsweise wenn das Fluid flüssig (z.B. eine Kühlflüssigkeit) ist und Wasser aufweist. Dies begünstigt die Lebensdauer einer Erfassungsvorrichtung, beispielsweise wenn diese selbst nicht wasserdicht ist oder gar keine eigene Verkapselung aufweist. Ist die Einhäusung vorhanden, kann die Haltevorrichtung 204 eingerichtet sein, die Einhäusung zu halten.

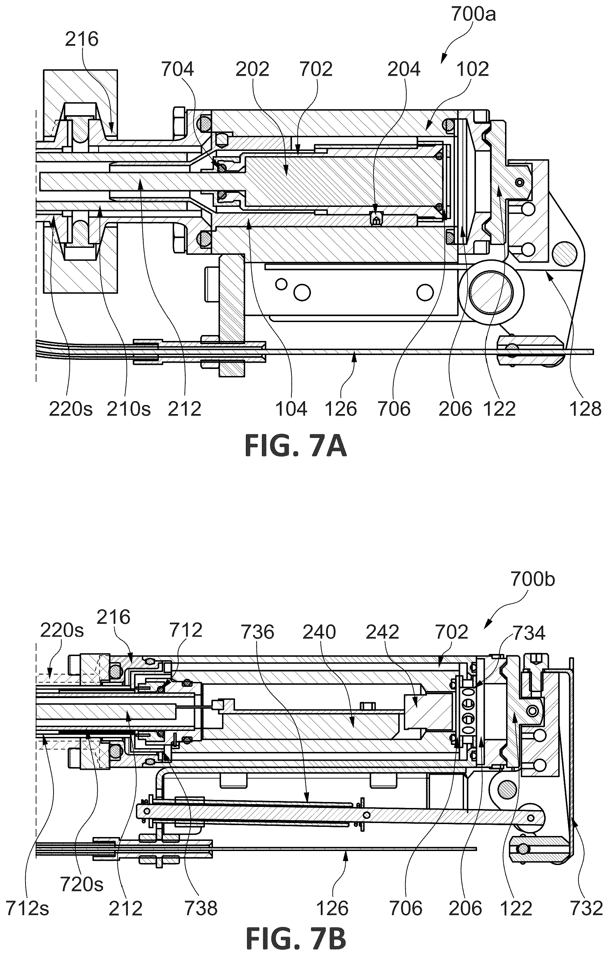

**Fig.7A** veranschaulicht ein Erfassungssystem gemäß verschiedenen Ausführungsformen 700a in einer schematischen Seitenansicht oder Querschnittsansicht, welches die Einhäusung 702 aufweist, z.B. gemäß einer der Ausführungsformen 100a bis 600 und/oder gemäß Beispiel 31 eingerichtet ist.

Eine exemplarische Implementierung der Einhäusung 702 weist mehrere (z.B. ineinander steckbare) Gehäuseteile (auch als dritte Gehäuseteile oder Einhäusungsteile bezeichnet), welche beispielsweise eingerichtet sind, fluiddicht (z.B. wasserdicht) zusammengefügt zu werden. Die Einhäusungsteile weisen ein erstes Einhäusungsteil auf, welches stirnseitig eine Lichtaufnahmewand 706 (auch als innere Lichtaufnahmewand bezeichnet) aufweist oder zumindest eingerichtet ist, dass daran ein zusätzliches Schauglas 706 (auch als inneres Schauglas bezeichnet), z.B. als Einhäusungsteil, montiert werden kann. Die Einhäusungsteile weisen ein zweites Einhäusungsteil auf, welches eine Kabeldurchführung 704 aufweist oder aufnehmen kann, welche beispielsweise dem Lichtaufnahmebereich abgewandt ist.

In dem Inneren der Einhäusung 702 (auch als Zwischenraum bezeichnet) kann die Kamera 202 (z.B. formschlüssig) und optional ein Gas aufgenommen sein, z.B. wenn die Einhäusung 702 an Atmosphäre montiert wird. Es kann verstanden werden, dass das Gas zumindest atmosphärische Luft aufweisen oder daraus bestehen kann, aber bei Bedarf auch eine andere chemische Zusammensetzung aufweisen kann, z.B. aus Stickstoff oder Trockenluft bestehen kann.

Eine exemplarische Implementierung der Kabeldurchführung 704 weist eine Ringdichtung auf, welche eine Durchgangsöffnung (auch als Kabelöffnung bezeichnet) der Kabeldurchführung 704 begrenzt, und einen Formschlussmechanismus, der eingerichtet ist, in Antwort darauf betätigt (z.B. gedreht) zu werden, die Ringdichtung gegen ein in der Kabelöffnung angeordnetes Kabel zu pressen. Diese Konfiguration führt das Kabel Eine exemplarische Implementierung des inneren Schauglases stellt die innere Lichtaufnahmewand 706 zumindest teilweise bereit und kann beispielsweise eine Glasplatte aufweisen. Eine exemplarische Implementierung der inneren Lichtaufnahmewand 706 ist zumindest abschnittweise mittels es inneren Schauglases bereitgestellt. Das innere Schauglas kann formschlüssig in einer Aussparung aufgenommen sein, welche zwischen zwei Montagevorrichtungen der Einhäusung (auch als innere Glas-Montagevorrichtungen bezeichnet) gebildet ist, die beispielsweise einen inneren Rahmen (z.B. Montagerahmen) bilden. Die innere Glas-Montagevorrichtungen sind eingerichtet, zusammengefügt, das innere Schauglas gegen eine Lichtaufnahmedichtung der Einhäusung zu pressen.

**Fig.7B** veranschaulicht das Erfassungssystem gemäß verschiedenen Ausführungsformen 700b in einer schematischen Ansicht, wenn die Abdeckklappe 122 in dem Offen-Zustand gebracht ist, z.B. z.B. gemäß einer der Ausführungsformen 100a bis 700a und/oder gemäß Beispiel 31.

Im Gegensatz zu den Ausführungsformen 700a weist die Einhäusung 702 anstatt der Kabeldurchführung 704 einen Schlauchanschluss 712 (auch als inneren Schlauchanschluss bezeichnet) auf, z.B. eine Schlauchtülle. Der innere Schlauchanschluss 712 ist eingerichtet, dass daran ein Schlauch 712s (auch als Zwischenschlauch 712s bezeichnet) montiert werden kann, der fluidleitend mit dem Zwischenraum gekoppelt ist. Beispielsweise weist der innere Schlauchanschluss 712 einen Hohlraum (auch als Anschlusshohlraum bezeichnet) auf, in welchen der Zwischenschlauch 712s eingesteckt sein oder werden kann. Der innere Schlauchanschluss 712 kann beispielsweise monolithisch mit dem zweiten Einhäusungsteil verbunden sein, muss dies aber nicht notwendigerweise (z.B. wenn dieser eingeschraubt ist). Mittels des inneren Schlauchanschluss 712 (z.B. dessen Anschlusshohlraum) kann im Betrieb der Zwischenschlauch 712s mit dem Zwischenraum fluidleitend gekoppelt sein.

Eine exemplarische Implementierung der Einhäusung 702, z.B. des ersten Einhäusungsteils dessen, weist eine oder mehr als eine Überlaufbohrung als Fluidkanal auf, welcher zwei Abschnitte des Aufnahmeraums (z.B. in dem Überlaufabschnitt 102h), zwischen denen die Haltevorrichtung 204 angeordnet ist, miteinander koppelt.

Eine exemplarische Implementierung der Erfassungsvorrichtung (z.B. gemäß Beispiel 34) weist einen starren Träger auf, an welchem eine Leiterplatte montiert ist. Die Leiterplatte weist einen Schaltkreis auf, welcher eingerichtet ist, eine Kommunikation zwischen dem Kabel 212 und dem Sensor 242 zu vermitteln.

Eine exemplarische Implementierung der Schutzvorrichtung weist ferner eine Abschirmung (z.B. Strahlungsabschirmung) auf, welche eine oder mehr als eine Abschirmwand aufweist und/oder in welcher das Überdruckgehäuse angeordnet ist. Eine Abschirmwand 732 der Abschirmung kann beispielsweise als Abschirmdeckel 732 (z.B. Schutzblech 732) und/oder mit der Abdeckklappe 122 (z.B. starr) gekuppelt sein.

Eine exemplarische Implementierung des inneren Schauglases 706 ist mittels eines (z.B. ringförmigen) Distanzstücks 734 gehalten und/oder mit dem äußeren Schauglas 206 gekuppelt. Beispielsweise kann eine Kraft mittels des Distanzstücks 734 von dem äußeren Schauglas 206 auf das innere Schauglas 706 übertragen, mittels welcher beispielsweise das innere Schauglas 706 gegen eine Dichtvorrichtung gepresst wird. Dies vereinfacht die Konstruktion. Optional kann das Distanzstück 734 ringförmig sein und/oder eine Vielzahl von Durchgangsöffnung aufweisen, welche den Fluidaustausch begünstigen.

Eine exemplarische Implementierung der Abdeckklappe 122 ist mit einem Federvorrichtung 736 (z.B. einer Druckfeder) gekuppelt, welche eingerichtet ist, eine Bewegung der Abdeckklappe 122 in den Geschlossen-Zustand anzuregen, beispielsweise eine Kraft zu erzeugen, welche die Bewegung anregt. Optional (nicht dargestellt) kann die Federvorrichtung 736 mittels einer Führungsvorrichtung (z.B. Führungsstange) mit einer Lagervorrichtung (z.B. einem Drehlager), mittels dessen die Abdeckklappe 122 beweglich gelagert ist, gekuppelt sein. Die Führungsvorrichtung sichert beispielsweise beim Schwenken von der Abdeckklappe 122 um den Drehpunkt der Lagervorrichtung eine gerade Verbindung zwischen den Anlenkpunkten und/oder hemmt ein Ausknicken der Federvorrichtung.

Eine exemplarische Implementierung weist ferner ein (z.B. rohrförmiges) Zwischenstück 738 auf, das eine Wasserführung begünstigt. Das Zwischenstück 738 kann beispielsweise einen Fluidanschluss aufweisen zum Anschließen des Zwischenschlauchs 712s und/oder in den Außenschlauch 220s hinein erstreckt sein. Alternativ oder zusätzlich kann der Innenschlauch 720s in dem Zwischenstück 738 angeordnet sein. Das Zwischenstück 738 begünstigt beispielsweise einen Überlauf des Kühlmediums vom Zwischenraum, der zwischen Außenschlauch 220s und Zwischenschlauch 712s gebildet ist, in die Vorlaufbohrungen und aus den Rücklaufbohrungen in den Zwischenraum, der zwischen dem Zwischenschlauch 712s und dem Innenschlauch 720s gebildet ist.

Im Folgenden werden verschiedene Arbeitsbeispiele beschrieben, die sich auf hierin Beschriebene und in den Figuren Dargestellte beziehen.

Gemäß Arbeitsbeispiel 1 ist eine Kamera mittels eines Schlauchsystems wassergekühlt und elektrisch versorgt. Dies vergrößert den Einsatzbereich, beispielsweise um die Kamera nahe des Prozessierbereichs als Quelle hoher Temperatur und/oder eines Beschichtungsmaterials anzuordnen.

Gemäß Arbeitsbeispiel 2 ist vor der Kamera (z.B. vakuumseitig und/oder in Erfassungsrichtung) ein Schauglas als transparente Wand angeordnet. Die hemmt die Verschmutzung der Kamera und begünstig deren Kühlung.

Gemäß Arbeitsbeispiel 3 ist vor dem Schauglas (z.B. vakuumseitig und/oder in Erfassungsrichtung) eine Blende angeordnet. Die Blende schützt das Schauglas vor Verschmutzung.

Gemäß Arbeitsbeispiel 4 ist eine Kamera, z.B. endoskopisch, mittels eines Kabels versorgt, das durch einen Vakuumflansch hindurch und innerhalb eines Doppelschlauches in die Schutzvorrichtung geführt ist. Der Außenschlauch, z.B. ein Wellrohrschlauch, stellt eine Trennung zum Vakuum bereit. Der Innenschlauch stellt eine Trennung von Vorlauf und Rücklauf der Wasserkühlung bereit.

Gemäß Arbeitsbeispiel 5 ist die Kamera in einem Überdruckgehäuse der Schutzvorrichtung angeordnet. Dort wird diese gehalten und mittels eines Überlaufs mit Kühlwasser umströmt. Vor der Kamera (z.B. in Erfassungsrichtung) ist ein Schauglas des Gehäuses angeordnet, welches das Kühlwasser vom Vakuum trennt. Das Schauglas ermöglicht den Durchblick der Kamera auf den Prozessierbereich.

Gemäß Arbeitsbeispiel 6 in Erfassungsrichtung vor dem Schauglas (z.B. in Erfassungsrichtung) eine Blende angeordnet, welche mittels eines Bowdenzugs und eines Hebelsystems geöffnet und mittels einer Feder (auch als Federvorrichtung bezeichnet) geschlossen wird.

Gemäß Arbeitsbeispiel 7 wird eine Endoskop-Kamera als Kamera verwendet, welche eine oder mehr als eine Lichtquelle (z.B. einen oder mehr als einen Lichtemissionsdiode) aufweist, die beispielsweise das Gehäuse der Endoskop-Kamera integriert ist. Dies verbessert die Ausleuchtung des Prozessierbereichs.

Gemäß Arbeitsbeispiel 8 wird alternativ oder zusätzlich zu der Lichtquelle der Kamera eine zusätzliche Lichtquelle verwendet, welche dem Vakuum ausgesetzt ist und/oder an der Vakuumkammer montiert ist. Die zusätzliche Lichtquelle kann beispielsweise eine Niedervolt (z.B. 12 Volt) Halogenlampe aufweisen, die auch für heiße Umgebungen geeignet ist, z.B. als Backofenlampe ausgeführt. Kleinen Halogenlampe sind kostengünstig und für Vakuum geeignet.

Gemäß Arbeitsbeispiel 9 wird die zusätzliche Lichtquelle mittels eines temperaturfesten Kabels, z.B. mit Glasseidenisolierung, und temperaturfesten Lampenhalterung, z.B. aus Keramik, betrieben.

Gemäß Arbeitsbeispiel 10 wird erfolgt die Bewegung der Blende mittels einer Kraft (z.B. Handkraft), die von einer Person erzeugt wird (auch als Handbettrieb bezeichnet) alternativ oder zusätzlich zu der Antriebsvorrichtung. Gemäß Arbeitsbeispiel 11 wird erfolgt die Bewegung der Blende mittels einer elektrischen und/oder eine pneumatischen Antriebsvorrichtung.

Gemäß Arbeitsbeispiel 12 ist die Schutzvorrichtung, in welcher die Kamera angeordnet ist, einem Vakuum ausgesetzt, und die Kamera einer Kühlflüssigkeit (z.B. Wasser) ausgesetzt.

Gemäß Arbeitsbeispiel 13 werden die Kamera und/oder das Kamerakabel wassergekühlt.

Gemäß Arbeitsbeispiel 14 wird die Blende wird nur bei Bedarf geöffnet und schützt das Schauglas und/oder die Kamera vor Verdreckung.

Gemäß Arbeitsbeispiel 15 werden die von der Kamera bereitgestellten Bildinformationen an einem beliebigen Ort, z.B. an der Anlagensteuerung, angezeigt und/oder weiterverarbeitet.

## Patentansprüche

1. Schutzvorrichtung, aufweisend:
• ein erstes Gehäuseteil (102) und ein zweites Gehäuseteil (104), welche eingerichtet sind, ineinandergesteckt zu werden zum Bilden eines Überdruckgehäuses (150), in welchem ein Hohlraum (151) zum Aufnehmen einer optischen Erfassungsvorrichtung (202) bereitgestellt ist;
• wobei das erste Gehäuseteil (102) einen transparenten Lichtaufnahmebereich (112) aufweist, welcher an den Hohlraum (151) angrenzt;
• eine dem Lichtaufnahmebereich (112) gegenüberliegende Montagevorrichtung (110) zum Montieren einer oder mehr als einer Fluidleitung an das Überdruckgehäuse (150);
• ein erster Fluidtransferkanal (106) und ein zweiter Fluidtransferkanal (116), wovon jeder Fluidtransferkanal den Hohlraum (151) mit der Montagevorrichtung fluidleitend koppelt.

2. Schutzvorrichtung gemäß Anspruch 1, wobei das erste Gehäuseteil (102) und das zweite Gehäuseteil (104) rohrförmig sind oder zumindest jede einen rohrförmigen Abschnitt aufweisen.

3. Schutzvorrichtung gemäß einem der Ansprüche 1 bis 2, wobei die Montagevorrichtung einen Schlauchanschluss aufweist, in welchen der erste Fluidtransferkanal (106) mündet und welcher von dem zweiten Gehäuseteil (104) hervorsteht.

4. Schutzvorrichtung gemäß einem der Ansprüche 1 bis 3,
wobei die Montagevorrichtung ein Zwischenstück aufweist, welches einen Flansch und eine dem Flansch gegenüberliegende zweite Dichtvorrichtung zum fluiddichten Ankuppeln an das Überdruckgehäuse (150) aufweist,
wobei der erste und der zweite Fluidtransferkanal in dem Zwischenstück münden.

5. Schutzvorrichtung gemäß einem der Ansprüche 1 bis 4, ferner aufweisend:
eine erste Dichtvorrichtung, welche den Lichtaufnahmebereich (112) umgibt; und
eine transparente Wand, welche an der ersten Dichtvorrichtung anliegt.

6. Schutzvorrichtung gemäß einem der Ansprüche 1 bis 5, wobei das zweite Gehäuseteil (104) eine Haltevorrichtung aufweist, welche eingerichtet ist, die Erfassungsvorrichtung (202) drehgesichert zu halten.

7. Schutzvorrichtung gemäß einem der Ansprüche 1 bis 6, wobei das zweite Gehäuseteil (104) eine Vertiefung aufweist, in welche der erste Fluidtransferkanal (106) mündet, und welche zumindest einen Bereich des Hohlraums (151) bereitstellt.
7. Schutzvorrichtung gemäß einem der Ansprüche 1 bis 7, ferner aufweisend:
eine Abdeckklappe (122), welche beweglich gelagert ist, so dass der Lichtaufnahmebereich (112), wenn die Abdeckklappe (122) in einem ersten Zustand gebracht ist, von der Abdeckklappe (122) abgedeckt wird, und, wenn die Abdeckklappe in einem ersten Zustand gebracht ist, freigelegt ist.

8. Schutzvorrichtung gemäß einem der Ansprüche 1 bis 7, wobei das zweite Gehäuseteil (104) eingerichtet ist, in das erste Gehäuseteil (102) hinein eingesteckt zu werden entlang einer Richtung, und wobei der zweite Fluidtransferkanal (116) entlang der Richtung eine größere Ausdehnung aufweist als der erste Fluidtransferkanal (106).

9. Schutzvorrichtung gemäß Anspruch 8, wobei der zweite Fluidtransferkanal (116) entlang der Richtung an einem Abschnitt des Hohlraums (151) vorbei erstreckt ist, in welchem der erste Fluidtransferkanal (106) mündet.

10. Schutzvorrichtung gemäß Anspruch 9, wobei der Abschnitt des Hohlraums (151) eine Ausdehnung entlang der Richtung aufweist, die größer ist als ein Abstand des ersten Fluidtransferkanals (106) und des zweiten Fluidtransferkanals (116) voneinander.

11. Schutzvorrichtung gemäß einem der Ansprüche 1 bis 10, wobei das erste Gehäuseteil (102) und das zweite Gehäuseteil (104) ein Metall aufweisen oder daraus bestehen.

12. Schutzvorrichtung gemäß einem der Ansprüche 1 bis 11, wobei das Überdruckgehäuse eingerichtet ist, einem Überdruck in dem Hohlraum aufzunehmen von mehr als 0,5 bar bezogen auf einen äußeren Druck, dem das Überdruckgehäuse ausgesetzt ist.

13. Verwenden der Schutzvorrichtung gemäß einem der Ansprüche 1 bis 12 im Vakuum.

14. Erfassungssystem, aufweisend:
• die Schutzvorrichtung gemäß einem der Ansprüche 1 bis 13,
• die Erfassungsvorrichtung (202), welche in dem Hohlraum (151) aufgenommen ist, wobei die Erfassungsvorrichtung (202) eine Kamera und/oder ein Lichtleiterkabel aufweist.

15. Verwenden des Erfassungssystems gemäß Anspruch 14 im Vakuum zum Erfassen von Bildinformationen mittels der Erfassungsvorrichtung.
